# EUROPEAN PATENT APPLICATION

(11) **EP 4 819 784 A1**
(43) Date of publication of application: **07.10.2026**
(21) Application number: 24915463.4
(22) Date of filing: 31.12.2024
(51) Int. Cl.: H05K 9/00, H04M 1/02

(54) **ELECTRONIC DEVICE INCLUDING CONDUCTIVE CONTACT MEMBER AND MANUFACTURING METHOD THEREOF**

(30) Priority: 03.01.2024 KR 20240001175; 08.03.2024 KR 20240033279
(71) Applicant: Samsung Electronics Co., Ltd., Suwon-si, Gyeonggi-do 16677 (KR)
(72) Inventor: OH, Jonggi, Suwon-si, Gyeonggi-do 16677 (KR); PARK, Hyein, Suwon-si, Gyeonggi-do 16677 (KR); LIM, Jaedeok, Suwon-si, Gyeonggi-do 16677 (KR); CHOI, Taekkyun, Suwon-si, Gyeonggi-do 16677 (KR)
(74) Representative: Arnold & Siedsma
(86) International application number: PCT/KR2024/021546
(87) International publication number: WO 2025/147052

(57) **Abstract**

An electronic device according to various embodiments of the present invention may comprise: a display configured to output image information on a surface facing a first direction; and a conductive contact member disposed on a surface facing the direction opposite to the first direction, of the display. The conductive contact member may comprise: a conductive woven layer including conductive fibers woven to cross each other; and a conductive adhesive layer positioned on one surface of the conductive woven layer and including an adhesive and conductive particles, wherein the conductive adhesive layer may include a first region and a second region in which more adhesives are positioned than the first region.

## Description

### [Technical Field]

An embodiment disclosed herein relates to an electronic device and, more particularly, to an electronic device including a conductive contact member.

### [Background Art]

An electronic device may include a conductive contact member providing electrical contact for grounding and/or shielding against electromagnetic interference (EMI) with respect to electrical components such as a board, an antenna, and a display. Conventionally, a solderable spring material such as beryllium foil, stainless steel foil, or copper foil has been press-processed and used as a grounding contact terminal of an electronic circuit board. Such a structure requires an expensive mold in manufacturing, and elasticity may be reduced when pressure equal to or greater than a yield strength is applied. Accordingly, a conductive contact member configured to provide electrical contact and/or shielding between electrical components by covering a foamed polymer (e.g., a polymer foam) with a conductive material may be used. The above-described conductive contact member may be referred to as a foam gasket or a conductive gasket.

The above information may be provided as related art to help an understanding of the disclosure. None of the above may be asserted as prior art related to the disclosure or used to determine the prior art.

### [Disclosure of Invention]

### [Technical Solution]

The electrical conductivity of a conductive contact member depends on an electrical conduction path formed when conductive particles dispersed in an adhesive layer come into contact with each other when pressure is applied to a foam gasket. Accordingly, in order to reduce contact resistance of the foam gasket and increase electrical conductivity, an internal structure of an electronic device should be designed such that an appropriate level of pressure is applied to the foam gasket.

However, since the conductive contact member requires an excessive level of pressure to obtain sufficient electrical conductivity in a small area, when the conductive contact member is disposed on the rear surface of a member such as a display, a repulsive force may become excessive, so that an attachment region of the conductive contact member may be visually recognized from the front surface of the display, and thus the exterior quality of the display may be degraded. In addition, when the ratio of conductive particles dispersed in the adhesive layer is increased in order to increase the electrical conductivity of the conductive contact member, the relative proportion of the adhesive may be reduced, and thus the adhesive force of the conductive contact member may be reduced.

In addition, when the adhesive force of the conductive contact member is excessively sensitive to pressure, electrical conductivity may change according to a change in pressure applied to the conductive contact member by an impact or acceleration applied to the electronic device, and thus antenna radiation performance or display quality may vary due to changes in electrical characteristics.

According to embodiments disclosed herein, a conductive contact member having stably high electrical conductivity under low pressure may be provided.

The technical subjects pursued in the disclosure are not limited to the above-mentioned technical subjects, and other technical subjects which are not mentioned herein may be clearly understood from the following description by those skilled in the art to which the disclosure pertains.

An electronic device according to various embodiments of the disclosure may include a display configured to output image information on a surface oriented in a first direction. The electronic device may include a conductive contact member disposed on a surface of the display oriented in a direction opposite to the first direction. The conductive contact member may include a conductive woven layer including woven conductive fibers. The conductive contact member may include a conductive adhesive layer disposed on one surface of the conductive woven layer so as to form depression regions and including an adhesive and conductive particles. The depression regions may have 10% or less of the adhesive compared to non-depression regions of the conductive adhesive layer.

A conductive contact member according to various embodiments of the disclosure may include a conductive woven layer including conductive fibers woven to intersect each other. The conductive contact member may include a conductive adhesive layer disposed on one surface of the conductive woven layer so as to form depression regions and including an adhesive and conductive particles. The depression regions may have 10% or less of the adhesive compared to non-depression regions of the conductive adhesive layer.

A method for manufacturing a conductive contact member according to various embodiments of the disclosure may include a coating operation of applying an adhesive and conductive particles onto a release film. The method for manufacturing the conductive contact member may include an attaching operation of attaching the release film, the adhesive, and the conductive particles onto a conductive woven layer. The method for manufacturing the conductive contact member may include a removing operation of removing the release film from the conductive woven layer.

Embodiments of the disclosure may provide a conductive contact member having low contact resistance and high electrical conductivity under low pressure and maintaining stable electrical properties against external impact or acceleration. In addition, an electronic device having the above-described advantages may be provided.

### [Brief Description of Drawings]

With regard to the description of the drawings, the same or like reference signa may be used to designate the same or like elements.
FIG. 1 is a block diagram of an electronic device in a network environment according to an embodiment of the disclosure.
FIG. 2A is a front perspective view of an electronic device according to an embodiment of the disclosure.
FIG 2B is a rear perspective view of the electronic device of FIG. 2A according to an embodiment of the disclosure.
FIG. 3 is an exploded perspective view of the electronic device of FIG. 2A, according to an embodiment of the disclosure.
FIG. 4 is a perspective view illustrating a conductive contact member according to various embodiments of the disclosure.
FIG. 5A is a cross-sectional view illustrating the conductive contact member according to various embodiments of the disclosure.
FIG. 5B is a cross-sectional view illustrating a conductive adhesive layer according to various embodiments of the disclosure.
FIG. 5C is a plan view illustrating the conductive adhesive layer according to various embodiments of the disclosure.
FIG. 5D is a plan view illustrating the woven conductive layer according to various embodiments of the disclosure.
FIG. 5E is a plan view illustrating a conductive adhesive layer according to various embodiments of the disclosure.
FIGS. 6A and 6B are cross-sectional views illustrating a state in which pressure is applied to a conductive contact member according to various embodiments of the disclosure.
FIG. 7A is a graph showing sheet resistance of a conductive contact member according to various embodiments.
FIG. 7B is a graph showing adhesive force of the conductive contact member according to various embodiments.
FIG. 7C is a graph showing changes in sheet resistance depending on pressure of conductive contact members according to the disclosure and a Comparative Example.
FIG. 8A is a flowchart illustrating a manufacturing process of a conductive contact member according to various embodiments.
FIG. 8B is a schematic view illustrating a manufacturing operation of the conductive contact member according to various embodiments.
FIG. 8C is a schematic view illustrating a manufacturing operation of the conductive contact member according to various embodiments.
FIG. 8D is a schematic view illustrating a manufacturing operation of the conductive contact member according to various embodiments.

### [Mode for the Invention]

Hereinafter, exemplary embodiments of the disclosure will be described in detail with reference to the accompanying drawings. In the drawings, for example, the sizes and shapes of members may be exaggerated for the sake of descriptive convenience and clarity, and modifications of the illustrated shapes may be expected when actually implemented. Therefore, the embodiment of the disclosure should not be construed to be limited to particular shapes of parts described and shown in the specification.

Throughout the drawings, the same or like reference numerals designate the same or like elements. As used in the specification, the term "and/or" includes any one of items enumerated and all combinations of one or more thereof.

Embodiments of the disclosure are provided to more completely explain the disclosure to those skilled in the art to which the disclosure pertains, various changes and modification in form may be made to the embodiments as described below, and the scope of the disclosure is not limited thereto. Rather, these embodiments are presented to more fully and completely describe the disclosure and completely transfer the idea of the disclosure to those skilled in the art.

Terms used in the specification are used to explain embodiments, and are not intended to limit the disclosure. Also, a singular expression in the specification may include a plural expression unless the singular expression is clearly specified in the context. As used herein, the term "comprise" or "comprising" is intended to specify the existence of mentioned shapes, numbers, steps, operations, elements, components, and/or groups thereof, and does not preclude the possible existence or addition of other shapes, numbers, steps, operations, elements, components, and/or groups thereof.

In the specification, relative terms such as "below", "above", "upper", "lower", "horizontal", and "vertical" may be used to describe the relationship between one element, layer, or area and any other element, layer, or area. It should be appreciated that, in addition to the directions illustrated in the drawings, these terms also include other directions.

As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. Such terms as "a first", "a second", "the first", and "the second" may be used to simply distinguish a corresponding element from another, and does not limit the elements in other aspect (e.g., importance or order). When a first element is referred to, with or without the term "operatively" or "communicatively", as "coupled with," "coupled to," "connected with," or "connected to" another element (e.g., a second element), it means that the element may be coupled/connected with/to the other element directly (e.g., wiredly), wirelessly, or via a third element.

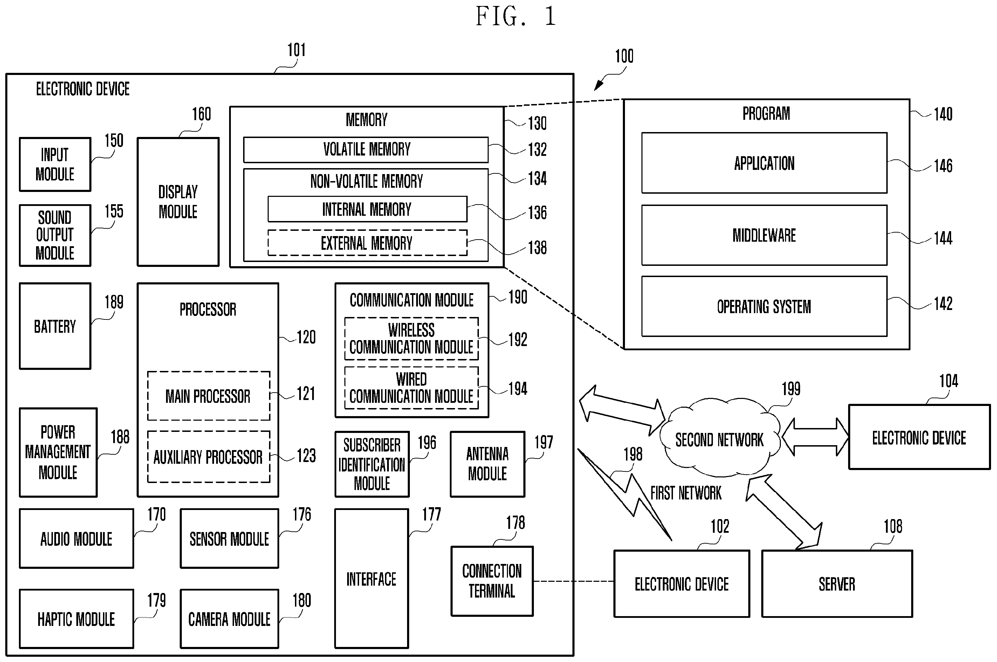

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

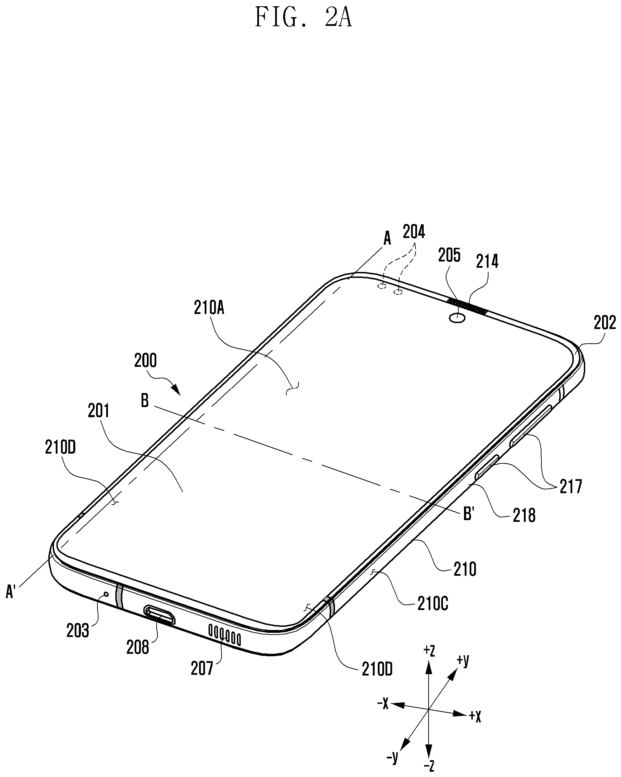

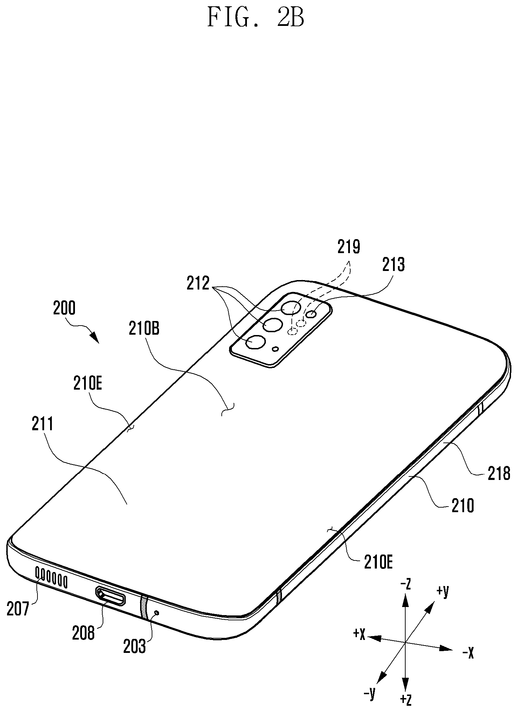

FIG. 2a is a front perspective view of an electronic device 200 (e.g., the electronic device 100 of FIG. 1) according to an embodiment of the present disclosure. FIG. 2b is a rear perspective view of the electronic device of FIG. 2a according to an embodiment of the present disclosure.

The electronic device 200 described below may include at least one of the components of the electronic device 101 described above with reference to FIG. 1.

Referring to FIGS. 2a and 2b, the electronic device 200 according to an embodiment may include a housing 210 that includes a first surface (or front surface) 210A, a second surface (or rear surface) 210B, and a lateral surface 210C that surrounds a space between the first surface 210A and the second surface 210B. The housing may refer to a structure that forms a part of the first surface 210A, the second surface 210B, and the lateral surface 210C of FIG. 2a. The first surface 210A may be formed of a front plate 202 (e.g., a glass plate or polymer plate coated with a variety of coating layers) at least a part of which is substantially transparent. The second surface 210B may be formed of a rear plate 211 which is substantially opaque. The rear plate 211 may be formed of, for example, coated or colored glass, ceramic, polymer, metal (e.g., aluminum, stainless steel (STS), or magnesium), or any combination thereof. The lateral surface 210C may be formed by a lateral bezel structure 218 (or "lateral member") which is combined with the front plate 202 and the rear plate 211 and includes a metal and/or polymer. The rear plate 211 and the lateral bezel structure 218 may be integrally formed and may be of the same material (e.g., a metallic material such as aluminum).

In the illustrated embodiment, the front plate 202 may include two first regions 210D disposed at both ends of long edges thereof, respectively, and bent and extended seamlessly from the first surface 210A toward the rear plate. In the illustrated embodiment (see FIG. 2b), the rear plate 211 may include two second regions 210E disposed at both ends of long edges thereof, respectively, and bent and extended seamlessly from the second surface 210B toward the front plate. In some embodiments, the front plate 202 or the rear plate 211 may include only one of the first regions 210D or the second regions 210E. In some embodiments, the front plate 202 may include only a flat plane disposed parallel to the second surface 210B, without including the first regions 210D and the second regions 210E. When viewed from a lateral side of the electronic device 200, the lateral bezel structure 218 may have a first thickness (or width) on a lateral side where the first region 210D or the second region 210E is not included, and may have a second thickness, being less than the first thickness, on another lateral side where the first region 210D or the second region 210E is included.

According to an embodiment, the electronic device 200 may include at least one of a display 201, an input device 203, audio output devices 207 and 214, sensor modules 204 and 219, camera modules 205 and 212, a key input device 217, an indicator (not shown), and a connector 208. In some embodiments, the electronic device 200 may omit at least one of the components (e.g., the key input device 217 or the indicator) or may further include other components.

The display 201 may be visually exposed through a substantial portion of the front plate 202, for example. At least a part of the display 201 may be visible through the front plate 202 that forms the first surface 210A and the first region 210D of the lateral surface 210C. The display201 may be combined with, or adjacent to, a touch sensing circuit, a pressure sensor capable of measuring the touch strength (pressure), and/or a digitizer for detecting a stylus pen. At least a part of the sensor modules 204 and 219 and/or at least a part of the key input device 217 may be disposed in the first region 210D and/or the second region 210E.

The input device 203 may include a microphone 203. In some embodiments, the input device 203 may include a plurality of microphones 203 disposed to detect the direction of a sound. The audio output devices 207 and 214 may include speakers 207 and 214. The speakers 207 and 214 may include an external speaker 207 and a receiver 214 for calls. In some embodiments, the microphone 203, speakers 207 and 214, and connector 208 may be at least partially disposed in an internal space of the electronic device 200, and may be exposed to the external environment through at least one hole formed in the housing 210. In some embodiments, the hole formed in the housing 210 may be commonly used for the microphone 203 and the speakers 207 and 214. In some embodiments, the audio output devices 207 and 214 may include a speaker (e.g., a piezo speaker) that operates without a hole formed in the housing 210.

The sensor modules 204 and 219 may generate electrical signals or data values corresponding to an internal operating state of the electronic device 200 or to an external environmental condition. The sensor modules 204 and 219 may include, for example, a first sensor module 204 (e.g., a proximity sensor) and/or a second sensor module (not shown) (e.g., a fingerprint sensor) disposed on the first surface 210A of the housing 210, and/or a third sensor module 219 (e.g., an HRM sensor) disposed on the second surface 210B of the housing 210. The fingerprint sensor may be disposed on the first surface 210A of the housing 210. The fingerprint sensor (e.g., a home key button) may be disposed on a partial area of the second surface 210B and/or below the display 201. The electronic device 200 may further include at least one of sensor modules not shown, for example, a gesture sensor, a gyro sensor, an air pressure sensor, a magnetic sensor, an acceleration sensor, a grip sensor, a color sensor, an IR (infrared) sensor, a biometric sensor, a temperature sensor, a humidity sensor, a proximity sensor, or an illuminance sensor.

The camera modules 205 and 212 may include a first camera module 205 disposed on the first surface 210A of the electronic device 200, and a second camera module 212 and/or a flash 213 disposed on the second surface 210B. The camera modules 205 and 212 may include one or more lenses, an image sensor, and/or an image signal processor. The flash 213 may include, for example, a light emitting diode or a xenon lamp. In some embodiments, two or more lenses (a wide-angle lens, an ultra-wide-angle lens, or a telephoto lens) and image sensors may be disposed on one surface of the electronic device 200.

The key input device 217 may be disposed on the lateral surface 210C of the housing 210. In other embodiments, the electronic device 200 may not include some or all of the aforementioned key input devices 217, and the key input device 217 that is not included may be implemented in another form such as a soft key on the display 201. In another embodiment, the key input device 217 may be implemented using a pressure sensor included in the display 201.

The indicator may be disposed on, for example, the first surface 210A of the housing 210. The indicator may provide, for example, status information of the electronic device 200 in an optical form (e.g., a light emitting element). In another embodiment, the light emitting element may provide, for example, a light source that is linked with the operation of the camera module 205. The indicator may include, for example, an LED, an IR LED, and/or a xenon lamp.

The connector hole 208 may include a first connector hole 208 adapted for a connector (e.g., a USB (universal serial bus) connector) for transmitting and receiving power and/or data to and from an external electronic device, and/or a second connector hole (or earphone jack) (not shown) adapted for a connector for transmitting and receiving an audio signal to and from an external electronic device.

Some camera modules 205 of the camera modules 205 and 212, some sensor modules 204 of the sensor modules 204 and 219, or an indicator may be arranged to be visually exposed through the display 201. For example, the camera module 205, the sensor module 204, or the indicator may be arranged in the internal space of the electronic device 200 so as to be in contact with an external environment through an opening or a transmission area of the display 201, which is perforated up to the front plate 202. According to an embodiment, an area of the display 201 facing the camera module 205 may be formed as a transmission area having a certain transmittance as a part of an area displaying content. According to an embodiment, the transmission area may be formed to have a transmittance in a range of about 5% to about 20%. The transmission area may include an area overlapping with a valid area (e.g., a field of view area) of the camera module 205 through which light that is imaged by an image sensor and generates an image passes. For example, the transmission area of the display 201 may include an area having a lower pixel density than the surroundings. For example, the transmission area may replace the opening. For example, the camera module 205 may include an under display camera (UDC). In another embodiment, some sensor modules 204 may be arranged to perform their functions without being visually exposed through the front plate 202 in the internal space of the electronic device. For example, in this case, an area of the display 201 facing the sensor module may not require a perforated opening.

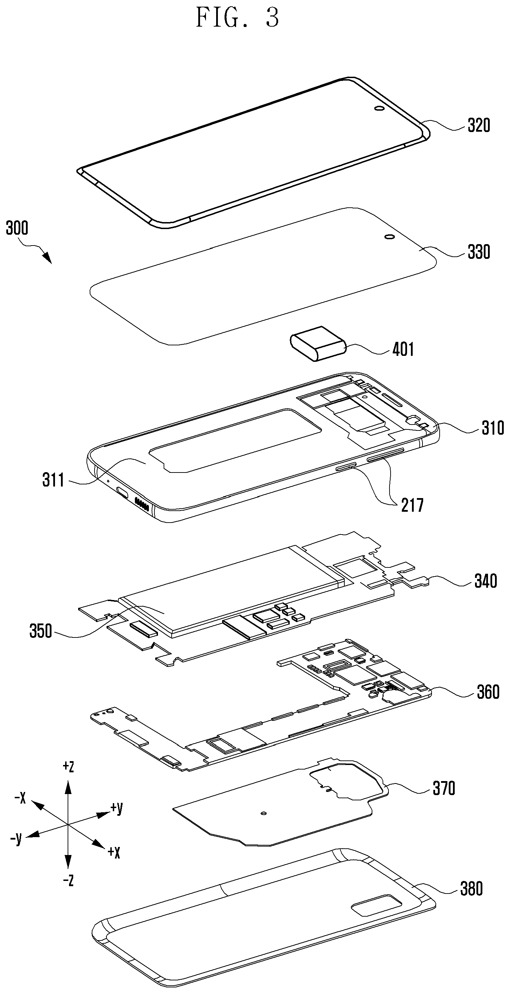

According to an embodiment, an electronic device 200 may have a bar type or plate type exterior, but the disclosure is not limited thereto. For example, the illustrated electronic device 200 may be a part of a foldable electronic device, a slidable electronic device, a stretchable electronic device, and/or a rollable electronic device. The terms "foldable electronic device," "slidable electronic device," "stretchable electronic device," and/or "rollable electronic device" may refer to an electronic device in which a display (e.g., the display 330 of FIG. 3) is bendable so that at least a portion of the display may be folded, wound or rolled, at least partially expanded in area, and/or accommodated inside a housing (e.g., the housing 210 of FIGS. 2A and 2B). The foldable electronic device, the slidable electronic device, the stretchable electronic device, and/or the rollable electronic device may be used by expanding a screen display region according to a user's need, by unfolding the display or exposing a wider area of the display to the outside.

FIG. 3 is an exploded perspective view of the electronic device of FIG. 2A, according to an embodiment of the disclosure.

The electronic device 300 of FIG. 3 may be at least partially similar to the electronic device 200 of FIG. 2b, or may include another embodiment of an electronic device.

Referring to FIG. 3, the electronic device 300 (e.g., the electronic device 200 of FIG. 2A or FIG. 2B) may include a side surface member 310 (e.g., a side surface bezel structure), a first support member 311 (e.g., a bracket or support structure), a front surface plate 320 (e.g., a front surface cover), a display 330 (e.g., the display 201 of FIG. 2A), a board 340 (e.g., a printed circuit board (PCB), a flexible printed circuit board (FPCB), or a rigid-flexible printed circuit board (RFPCB)), a battery 350, a second support member 360 (e.g., a rear case), an antenna 370, and a rear surface plate 380 (e.g., a rear surface cover). In an embodiment, the electronic device 300 may omit at least one of the components (e.g., the first support member 311 or the second support member 360) or may additionally include another component. At least one of the components of the electronic device 300 may be the same as or similar to at least one of the components of the electronic device 200 of FIG. 2A or FIG. 2B, and a repeated description will be omitted below.

The first support member 311 may be disposed inside the electronic device 300 and connected to the side surface member 310, or may be integrally formed with the side surface member 310. The first support member 311 may be formed of, for example, a metal material and/or a non-metal material (e.g., a polymer). The display 330 may be coupled to one surface of the first support member 311, and the board 340 may be coupled to the other surface of the first support member 311. A processor, a memory, and/or an interface may be mounted on the board 340. The processor may include, for example, one or more of a central processing unit, an application processor, a graphics processing unit, an image signal processor, a sensor hub processor, or a communication processor.

The memory may include, for example, volatile memory or non-volatile memory.

The interface may include, for example, a high-definition multimedia interface (HDMI), a universal serial bus (USB) interface, an SD) card interface, and/or an audio interface. The interface may, for example, electrically or physically connect the electronic device 300 to an external electronic device, and may include a USB connector, an SD card/an MMC connector, or an audio connector.

The battery 350, as a device for supplying power to at least one component of the electronic device 300, may include, for example, a non-rechargeable primary battery, a rechargeable secondary battery, or a fuel cell. At least a portion of the battery 350 may be disposed, for example, substantially on the same plane as the board 340. The battery 350 may be integrally disposed inside the electronic device 300. In another embodiment, the battery 350 may be detachably disposed on the electronic device 300.

The antenna 370 may be disposed between the rear surface plate 380 and the battery 350. The antenna 370 may include, for example, a near field communication (NFC) antenna, a wireless charging antenna, and/or a magnetic secure transmission (MST) antenna. The antenna 370 may, for example, perform short-range communication with an external device or wirelessly transmit and receive power required for charging. In another embodiment, an antenna structure may be formed by a portion of the side surface bezel structure 310 and/or the first support member 311, or a combination thereof.

In various embodiments, the electronic device 300 may include a conductive contact member 401. The conductive contact member 401 may be disposed on a surface of a member, for example, the display 330, a frame (e.g., the first support member 311), the board 340, the antenna 370, and/or the rear surface plate 380, and may make electrical contact with other members facing the members.

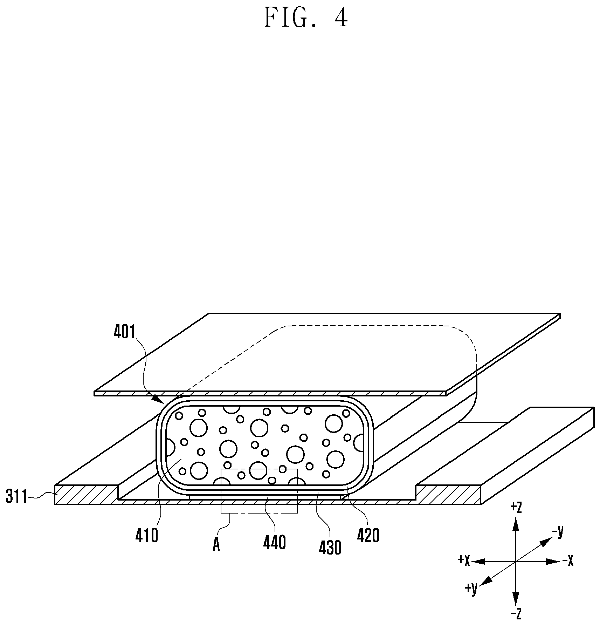

FIG. 4 is a perspective view illustrating a conductive contact member 401 according to various embodiments of the disclosure.

Referring to FIG. 4, the conductive contact member 401 may include a conductive woven layer 430 and a conductive adhesive layer 440.

The conductive woven layer 430 may include a conductive material and may be a layer that surrounds at least a portion of an outer periphery of the conductive contact member 401 to form a path through which current flows. For example, the conductive contact member 401 may come into contact with the display 330 in a first direction (e.g., the +z direction in the drawing) and may come into contact with a frame (e.g., the first support member 311) in a second direction opposite to the first direction (e.g., the -z direction in the drawing), and the conductive woven layer 430 may form a ground path between the display 330 and the frame.

The conductive adhesive layer 440 may be formed on at least a portion of one surface of the conductive woven layer 430 and may be a layer that adheres the conductive contact member 401 to a counterpart 402 that comes into contact with the conductive contact member 401 (e.g., the display 330 and/or the first support member 311), while bringing the conductive contact member 401 into electrical contact with the counterpart 402. Detailed configurations of the conductive adhesive layer 440 and the conductive woven layer 430 will be described below.

In various embodiments, the conductive contact member 401 may include a foamed polymer layer 410. The foamed polymer layer 410 may include a porous material in which a polymer material such as polyurethane, polystyrene, ethylene-vinyl acetate, nitrile butadiene rubber (NBR), and/or polyolefin is foam-processed to form a plurality of pores. The foamed polymer layer 410 may impart elasticity to the conductive contact member 401. In various embodiments, the conductive contact member 401 may include a first adhesive layer 420 that bonds the foamed polymer layer 410 and the conductive woven layer 430 to each other.

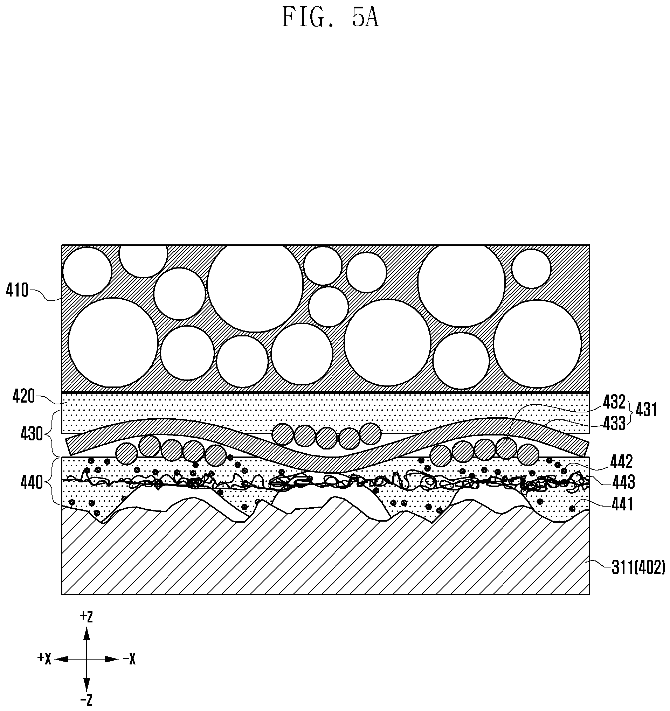

FIG. 5A is a cross-sectional view illustrating a conductive contact member 401 according to various embodiments of the disclosure.

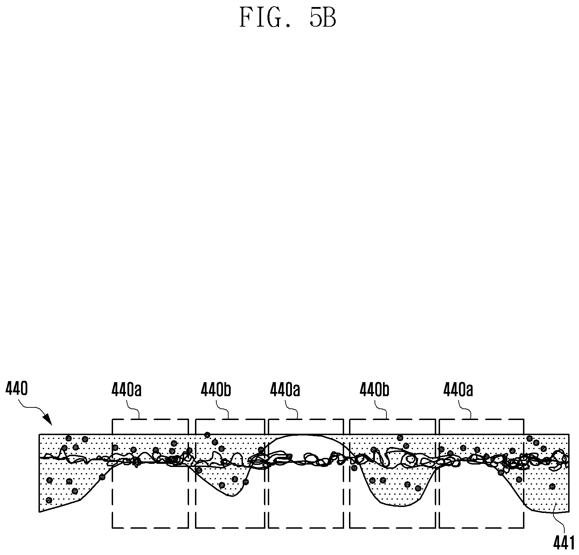

FIG. 5B is a cross-sectional view illustrating a conductive adhesive layer 440 according to various embodiments of the disclosure.

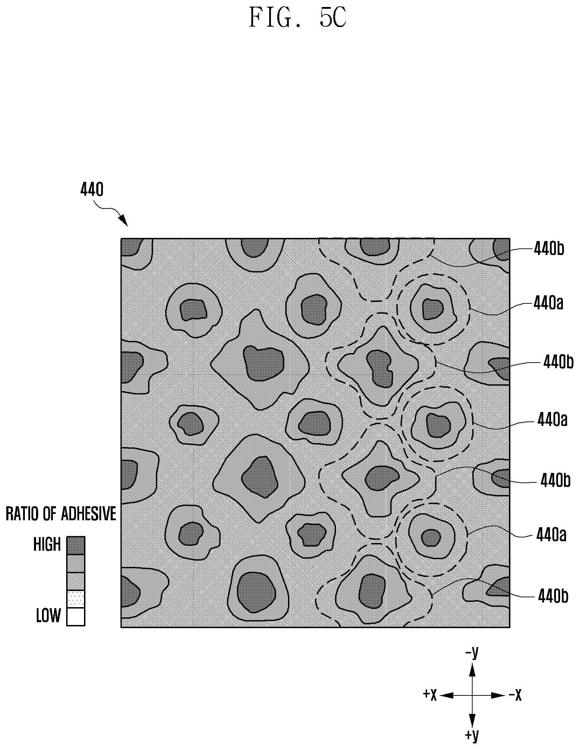

FIG. 5C is a plan view illustrating the conductive adhesive layer 440 according to various embodiments of the disclosure.

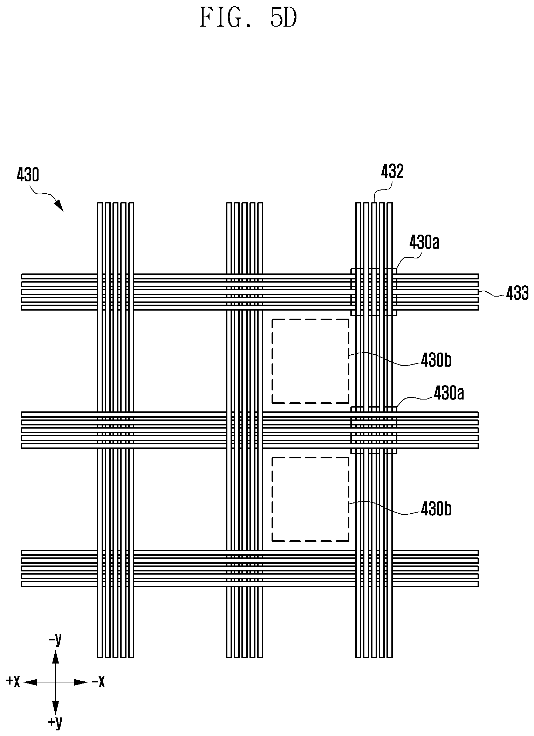

FIG. 5D is a plan view illustrating a woven conductive layer 430 according to various embodiments of the disclosure.

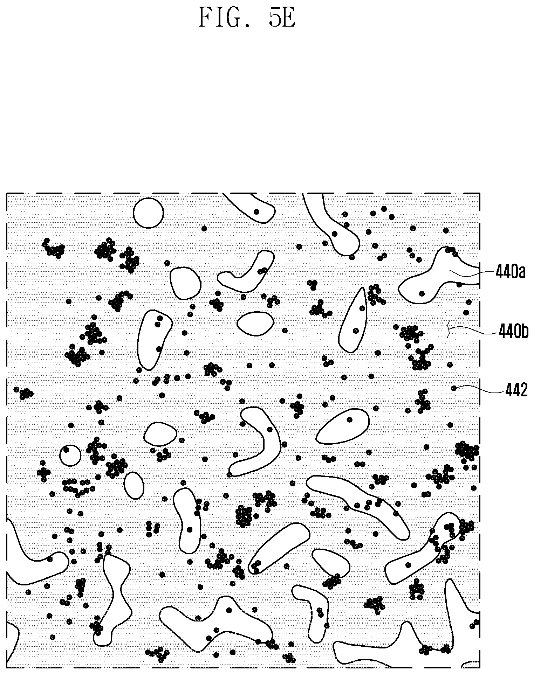

FIG. 5E is a plan view illustrating the conductive adhesive layer 440 according to various embodiments of the disclosure.

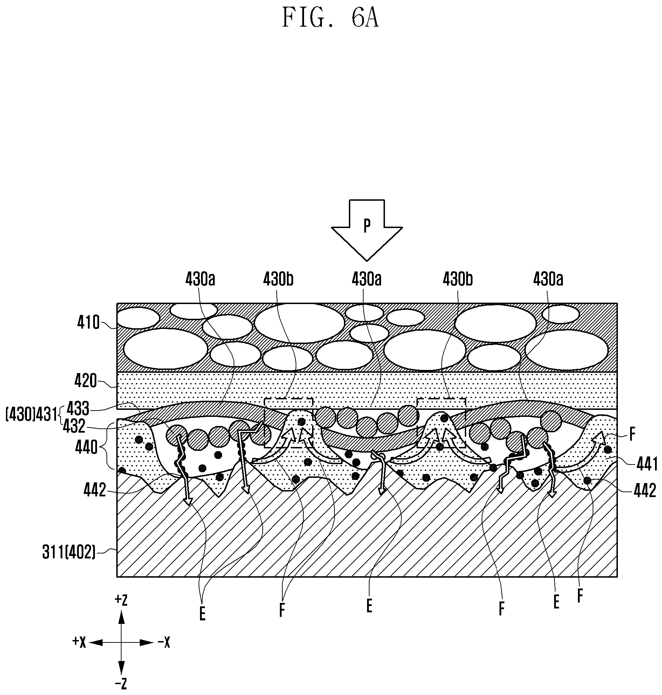

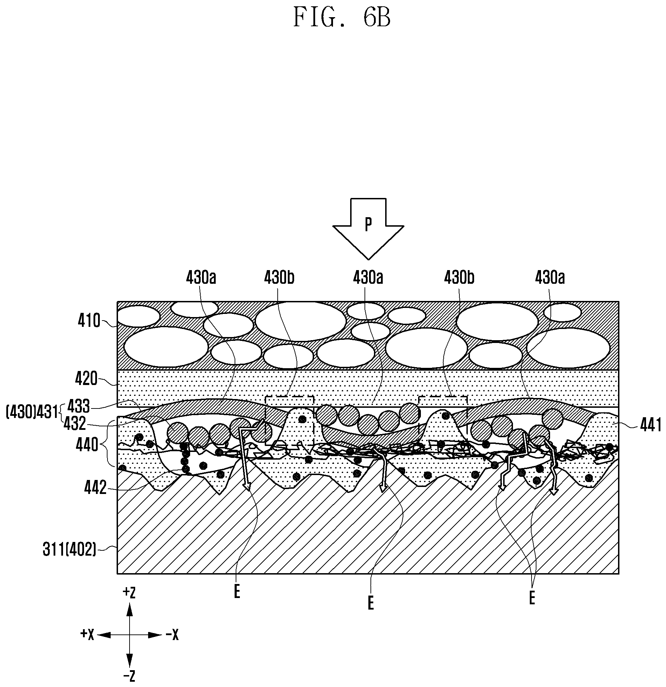

FIG. 5A is an enlarged view of region A of FIG. 4. FIG. 5A is also a cross-sectional view illustrating a state in which pressure (the pressure P of FIGS. 6A and 6B) is not applied to the conductive contact member 401.

Referring to FIGS. 5A to 5E, the conductive woven layer 430 may include conductive fibers 431. The conductive fibers 431 may include fibers having a conductive material (e.g., carbon fibers, metal fibers, and/or conductive polymer fibers), fibers of a composite material including a conductor, and/or fibers having a conductive coating (e.g., a deposited metal layer). The conductive fibers 431 may include weft fibers 432 and warp fibers 433. The weft fibers 432 and the warp fibers 433 may be woven to intersect each other at an angle (e.g., substantially a right angle). In some embodiments, the weft fibers 432 and the warp fibers 433 may be woven to intersect each other in units of a plurality of strands of fibers (e.g., five strands of fibers), as illustrated in FIGS. 5A and 5D.

The conductive adhesive layer 440 may include an adhesive 441 and conductive particles 442. The adhesive 441 may adhere the conductive woven layer 430 of the conductive contact member 401 to a counterpart 402 that is in contact with the conductive woven layer 430 (e.g., the display 330 and/or the first support member 311) so as to fix the conductive woven layer 430 to the counterpart 402. The conductive particles 442 may be members that bring the counterpart 402, which is in contact with the conductive contact member 401, and the conductive woven layer 430 into electrical contact with each other to form a conductive path. The conductive particles 442 may be dispersed (suspended) in the adhesive 441. The conductive particles 442 may include, for example, particles of a conductive material such as copper, aluminum, silver, gold, nickel, and stainless steel. The diameter of the conductive particles 442 may be, for example, 2 micrometers or less based on D50 (median particle size).

In various embodiments, the conductive adhesive layer 440 may include a conductive nonwoven fabric 443. The conductive nonwoven fabric 443 may be a layer formed by entangling fibers of a material that is the same as or similar to a material of the conductive fibers 431 of the conductive woven layer 430. The conductive nonwoven fabric 443 may be at least partially deposited or dispersed in the adhesive 441 of the conductive adhesive layer 440. The adhesive 441 may be at least partially impregnated into the conductive nonwoven fabric 443.

Referring to FIGS. 5B and 5C, the conductive adhesive layer 440 may include depression regions 440a and non-depression regions 440b. The depression regions 440a may be regions in which relatively less adhesive 441 is disposed than in the non-depression regions 440b (e.g., 10% or less of the non-depression regions 440b). The non-depression regions 440b may be regions of the conductive adhesive layer 440 other than the depression regions 440a. The non-depression regions 440b may be regions in which relatively more adhesive 441 is disposed than in the non-depression regions 440b. For example, the depression regions 440a may be regions from which all or part of the adhesive 441 applied to the conductive adhesive layer 440 is removed. The first regions may be referred to as craters because all or part of the adhesive 441 (e.g., 90% or more) is removed. One or a plurality of depression regions 440a and non-depression regions 440b may be formed in the conductive adhesive layer 440. The depression regions 440a and the non-depression regions 440b may be regularly or irregularly disposed in the conductive adhesive layer 440. In FIG. 5C, the depression regions 440a and the non-depression regions 440b are regularly illustrated, but this is merely exemplary and does not limit the disclosure. The conductive adhesive layer 440 includes depression regions 440a in which less adhesive 441 is disposed or at least a portion of the adhesive 441 is removed, and non-depression regions 440b in which more adhesive 441 is disposed than in the depression regions 440a, so that the adhesive 441 may easily flow when pressure is applied to the conductive adhesive layer 440, as will be described below with reference to FIGS. 6A and 6B. In various embodiments, the conductive adhesive layer 440 may have a thickness of 7 micrometers or more. When the thickness of the conductive adhesive layer 440 is 7 micrometers or less, the adhesive 441 may not smoothly flow. In an embodiment, when the conductive adhesive layer 440 has a thickness of 7 micrometers or less, it may become difficult to apply the adhesive 441.

Referring again to FIGS. 5A and 5D, the conductive woven layer 430 may have regions 430a in which the weft fibers 432 and the warp fibers 433 intersect each other, and gaps 430b formed between the weft fibers 432 and the warp fibers 433. Since the regions 430a in which the weft fibers 432 and the warp fibers 433 intersect each other have a greater thickness than other regions of the conductive woven layer 430, a distance to a counterpart 402 that comes into contact with the conductive contact member 401 (e.g., the display 330 and/or the first support member 311) may be short, and thus electrical contact may be easily made.

Referring to FIGS. 5C and 5D, the depression regions 440a of the conductive adhesive layer 440 may be disposed to at least partially overlap the regions 430a in which the weft fibers 432 and the warp fibers 433 of the conductive woven layer 430 intersect each other. As will be described below, the depression regions 440a are disposed in the intersecting regions 430a, in which the distance to the counterpart 402 is short and electrical contact with the counterpart 402 may be easily made, thereby reducing the thickness of the adhesive 441 layer and relatively increasing the ratio of the conductive particles 442, so that sheet resistance between the conductive contact member 401 and the counterpart 402 may be reduced. In addition, in various embodiments, the conductive woven layer 430, the conductive nonwoven fabric 443, and the counterpart 402 may come into direct contact with each other in the depression regions 440a, so that sheet resistance between the conductive contact member 401 and the counterpart 402 may also be reduced. The non-depression regions 440b of the conductive adhesive layer 440 may at least partially overlap the gaps 430b formed between the weft fibers 432 and the warp fibers 433 of the conductive woven layer 430. For example, the depression regions 440a may correspond to the regions 430a of the conductive woven layer 430 in which the weft fibers 432 and the warp fibers 433 intersect each other, and the non-depression regions 440b may correspond to the gaps 430b between the fibers. Accordingly, when pressure is applied to the conductive contact member 401 as will be described below, the adhesive may easily penetrate into the gaps 430b between the fibers of the conductive woven layer 430.

Referring to FIG. 5E, in various embodiments, the depression regions 440a may have an irregular shape. For example, the non-depression regions 440b may be formed by aggregation of the adhesive 441 according to aggregation of the conductive particles 442, and the depression regions 440a may be formed in regions in which the adhesive 441 is at least partially depleted due to aggregation of the adhesive 441 toward the non-depression regions 440b. The depression regions 440a may be spaced apart from each other by the non-depression regions 440b. In various embodiments, the areal number density of the conductive particles 442 in the depression regions 441a may be 70% or less of the areal number density of the conductive particles 442 in the non-depression regions 440b.

FIGS. 6A and 6B are cross-sectional views illustrating a state in which pressure is applied to a conductive contact member 401 according to various embodiments of the disclosure.

Although FIG. 6A is illustrated with the conductive nonwoven fabric 443 omitted for clarity, it will be apparent to those ordinarily skilled in the art that a conductive nonwoven fabric 443 as illustrated in FIGS. 5A and 6B may be additionally coupled to the embodiment illustrated in FIG. 6A.

Referring to FIG. 6A, pressure P may be applied to the conductive contact member 401. Due to the pressure, the adhesive 441 of the conductive adhesive layer 440 may penetrate into the gaps 430b formed between the weft fibers 432 and the warp fibers 433 of the conductive woven layer 430. As the adhesive 441 penetrates into the gaps 430b of the conductive woven layer 430, the adhesive 441 of the conductive adhesive layer 440 may flow F from the regions 430a in which the weft fibers 432 and the warp fibers 433 intersect to the gaps 430b. For example, due to the flow F of the adhesive 441, the adhesive 441 may be completely or partially removed from the regions of the adhesive layer 440 overlapping the regions 430a in which the weft fibers 432 and the warp fibers 433 intersect. Accordingly, in the regions of the conductive adhesive layer 440 overlapping the regions 430a in which the weft fibers 432 and the warp fibers 433 intersect, the ratio of the adhesive 441 may relatively decrease, and the ratio of the conductive particles 442 may relatively increase. Due to a relative increase in the ratio of the conductive particles 442 in one region of the adhesive layer, formation of a conductive path E between the conductive woven layer 430 and a counterpart object 402 (e.g., the display 330 and/or the first support member 311) in the corresponding region may be facilitated.

In addition, as the adhesive 441 flows into the gaps 430b formed between the weft fibers 432 and the warp fibers 433 of the conductive woven layer 430, in the regions of the conductive adhesive layer 440 overlapping the gaps 430b, the ratio of the adhesive 441 may relatively increase, and the ratio of the conductive particles 442 may relatively increase. Accordingly, in the corresponding regions, the adhesive force of the conductive adhesive layer 440 may be improved, and the conductive woven layer 430 and the counterpart object 402 (e.g., the display 330 and/or the first support member 311) may be effectively fixed to each other.

In general, the adhesive force and electrical conductivity of the conductive adhesive layer 440 of the conductive contact member 401, such as a foam gasket, are in a trade-off relationship with each other. For example, when the ratio of the adhesive 441 is relatively increased to improve the adhesive force of the conductive adhesive layer 440, the ratio of the conductive particles 442 may relatively decrease, so that electrical conductivity may decrease and sheet resistance may increase. In addition, when the ratio of conductivity is relatively increased to improve the electrical conductivity of the conductive adhesive layer 440, the ratio of the adhesive 441 may relatively decrease, so that the adhesive force may decrease. In addition, in order to make high adhesive force and high electrical conductivity compatible with each other, the conductive contact member 401 may need to be pressed against the counterpart object 402 with excessively strong pressure so that the conductive particles 442 may come into contact with each other to form a conductive path. Accordingly, there may be a risk that the counterpart object 402 is damaged or that the external appearance quality of the display 330 may be degraded as the portion pressed by the conductive contact member 401 on the rear surface of the display 330 is visually recognized from the front surface.

According to the disclosure, when pressure is applied to the conductive adhesive layer 440, in the portions overlapping the regions 430a in which the weft fibers 432 and the warp fibers 433 of the conductive woven layer 430 intersect each other, the ratio of the conductive particles 442 may increase so that an electrical conduction path may be easily formed, thereby achieving low sheet resistance and high electrical conductivity, and in the portions overlapping the gaps 430b between the weft fibers 432 and the warp fibers 433, the ratio of the adhesive 441 may increase so that adhesive force may increase, and thus high electrical conductivity and high adhesive force may be compatible with each other.

Referring to FIG. 6B, when pressure P is applied to the conductive contact member 401, the conductive woven layer 430 may come into direct contact with the conductive nonwoven fabric 443. For example, by the flow F of the adhesive of the conductive adhesive layer 440 illustrated in FIG. 6A and/or by the overlap between the gaps 430b and the depression regions 440a as illustrated in FIGS. 5C and 5D, the regions 430a in which the conductive fibers 431 of the conductive woven layer 430 intersect each other may be in direct contact with the conductive nonwoven fabric 443 to form a conductive path E. Since the thickness of the conductive woven layer 430 is relatively greater in the regions 430a in which the conductive fibers 431 intersect each other, the above-described direct contact may be easily made, and contact resistance between the conductive contact member 401 and the counterpart 402 may be reduced.

It will be apparent to those ordinarily skilled in the art that formation of the conductive path E by the conductive particles 442 illustrated in FIG. 6A and formation of the conductive path E by direct contact between the conductive woven layer 430 and the conductive nonwoven fabric 443 illustrated in FIG. 6B are not contradictory to each other, and various embodiments of the disclosure may include the embodiments illustrated in FIG. 6A or FIG. 6B, or a combination thereof.

Referring to FIGS. 5E, 6A, and 6B, the inside of the depression regions 440a may be spaces closed by the adhesive 441. For example, the depression regions may be spaces closed by the first adhesive layer 420 on an upper side, by the adhesive 441 on lateral sides, and by the adhesive 441 and/or the counterpart 402 on a lower side. Accordingly, introduction of corrosion-causing elements such as external oxygen and/or moisture into the depression regions 440a may be limited or blocked. Accordingly, with respect to electrical contact made in the depression regions 440a, deterioration in performance of the electrical contact due to corrosion of conductive elements (e.g., the conductive particles 442, the conductive fibers 431, and/or the conductive nonwoven fabric 443), that is, an increase in contact resistance, may be reduced or prevented.

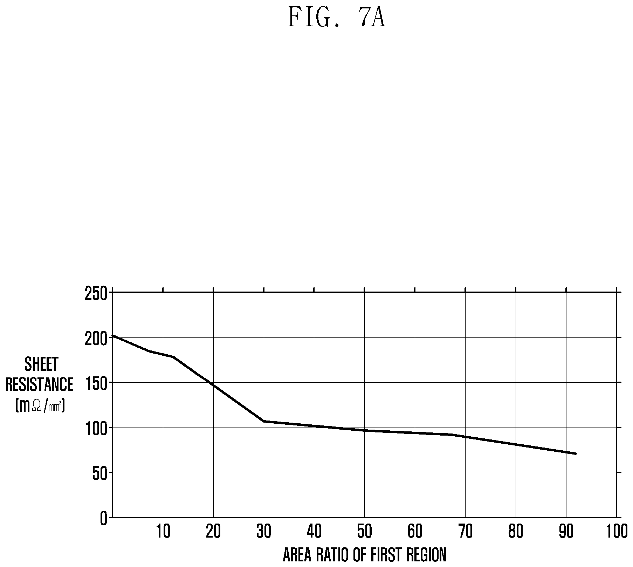

FIG. 7A is a graph showing sheet resistance of a conductive contact member 401 according to various embodiments.

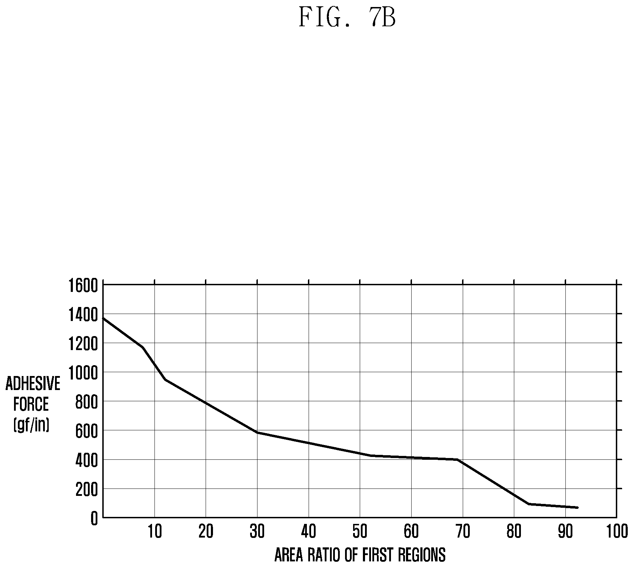

FIG. 7B is a graph showing adhesive force of the conductive contact member 401 according to various embodiments.

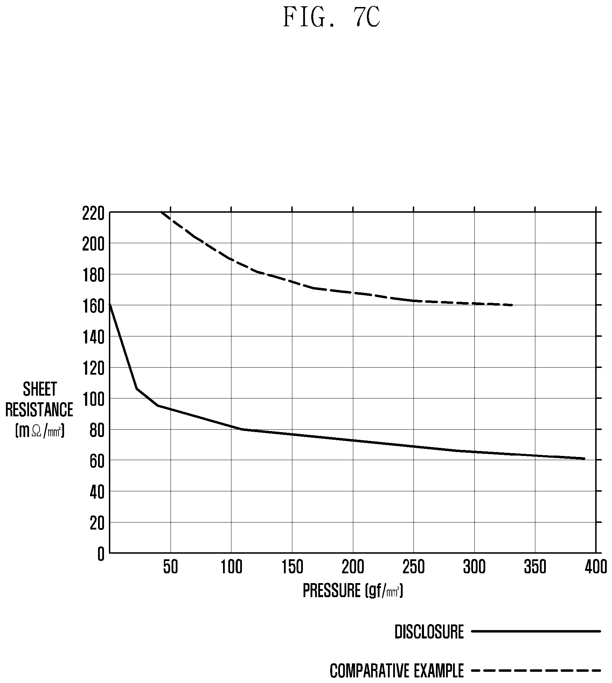

FIG. 7C is a graph showing changes in sheet resistance depending on pressure of conductive contact members according to the disclosure and a Comparative Example.

Referring to FIG. 7A, the area ratio of depression regions 440a in a conductive adhesive layer 440 of the conductive contact member 401 may be 30% or more. In various embodiments, when pressure of 30 gf/mm² is applied to the conductive contact member 401, it may be seen that sheet resistance sharply decreases until the area ratio of the depression regions 440a reaches 30%. In addition, referring to FIG. 7B, the area ratio of the depression regions 440a may be 70% or less. When the area ratio of the depression regions 440a exceeds 70%, it may be seen that adhesive force sharply decreases to 400 g/in or less. Accordingly, when the area ratio of the depression regions 440a of the conductive adhesive layer 440 of the disclosure is 30% to 70%, good adhesive force and electrical conductivity (i.e., low sheet resistance) may be obtained.

Referring to FIG. 7C, it may be seen that the conductive contact member 401 according to the disclosure has lower sheet resistance and higher electrical conductivity than the Comparative Example within all pressure ranges. Specifically, it may be seen that pressure of about 75 gf/mm² or more should be applied for the conductive contact member of the Comparative Example to have sheet resistance of 200 milliohms/mm². Such high pressure may cause a pressed mark to be visually recognized on the front surface of the display 330 when the conductive contact member is applied to the rear surface of the display 330, and thus may degrade exterior quality of the display 330. In addition, when pressure of 25 gf/mm² or less is applied, it may be seen that sheet resistance is excessively high.

In contrast, it may be seen that the conductive contact member 401 according to the disclosure has sheet resistance of 200 milliohms/mm² or less (e.g., about 110 ohms/mm²) at pressure of 25 gf/mm². Accordingly, it may be seen that the conductive contact member 401 of the disclosure may have sufficient electrical conductivity under low pressure, and thus a risk of excessive pressed marks occurring when the conductive contact member 401 is applied to the rear surface of the display 330 may be reduced.

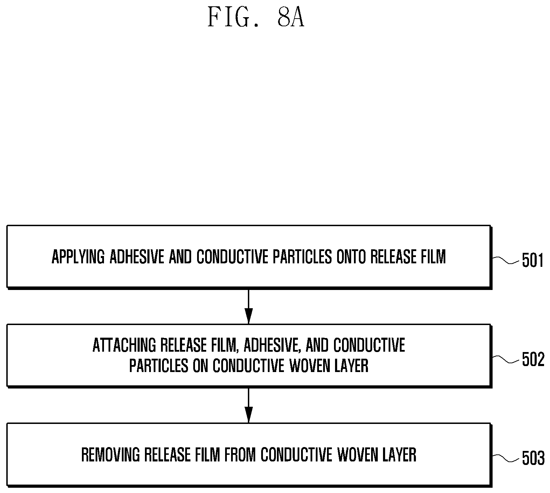

FIG. 8A is a flowchart illustrating a manufacturing process of a conductive contact member 401 according to various embodiments.

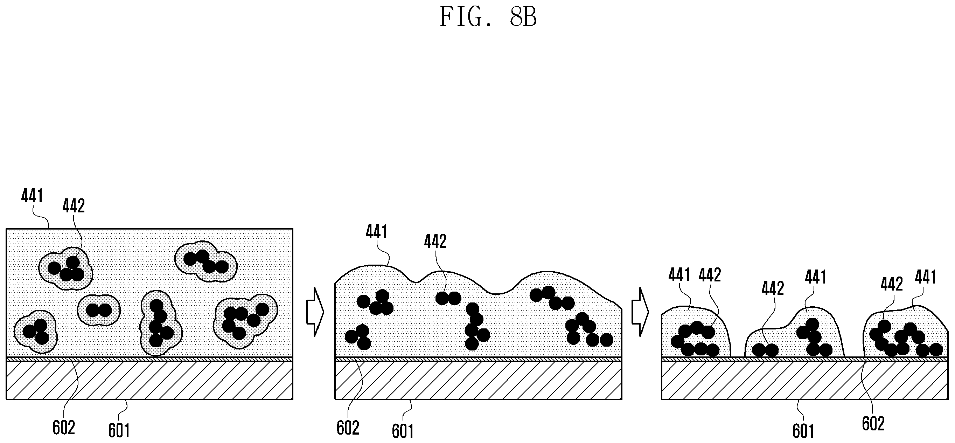

FIG. 8B is a schematic view illustrating a manufacturing operation of the conductive contact member 401 according to various embodiments.

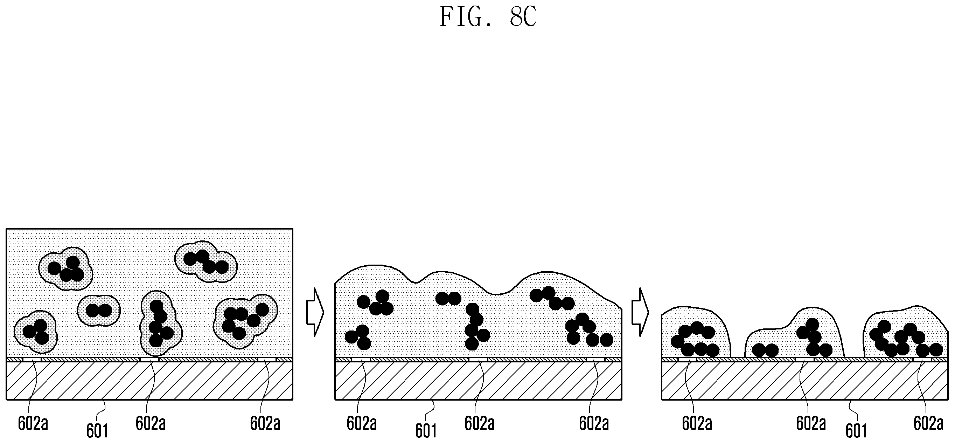

FIG. 8C is a schematic view illustrating a manufacturing operation of the conductive contact member 401 according to various embodiments.

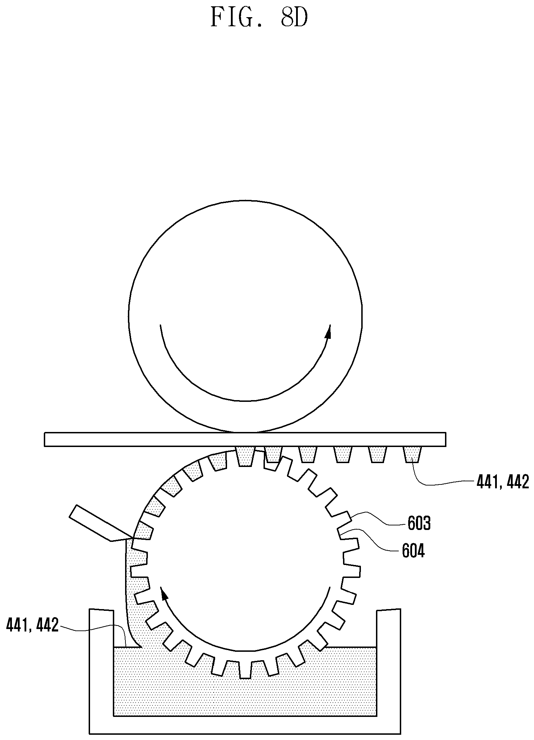

FIG. 8D is a schematic view illustrating a manufacturing operation of the conductive contact member 401 according to various embodiments.

Referring to FIG. 8A, the conductive contact member 401 may be manufactured by operations including an operation of applying an adhesive 441 and conductive particles 442 onto a release film 601 (a coating operation 501), an operation of attaching the adhesive 441 and the conductive particles 442 applied onto the release film 601 onto a conductive woven layer 430 (an attaching operation 502), and an operation of removing the release film 601 from the conductive woven layer 430 (a removing operation 503). In some embodiments, after the adhesive 441 and the conductive particles 442 are applied onto the release film 601, an operation of impregnating the adhesive 441 into a conductive nonwoven fabric 443 may be performed.

Referring to FIG. 8B, the operation 501 of applying the adhesive 441 and the conductive particles 442 onto the release film 601 may include an operation of applying the adhesive 441 in which the conductive particles 442 are dispersed onto the release film 601 through an apparatus such as a comma coater.

In various embodiments, a coating layer 602 having low interfacial energy with respect to the adhesive 441 (e.g., a silicone material coating) may be formed on the release film 601 so as to allow the release film 601 and the adhesive 441 to be easily separated when the release film 601 is removed in the removing operation.

In various embodiments, the conductive particles 442 dispersed in the adhesive 441 may cause the adhesive 441 to aggregate on the release film 601 so as to have an uneven thickness. For example, since the release film 601 has low interfacial energy with respect to the adhesive 441 and the conductive particles 442 have relatively high interfacial energy, the adhesive 441 may aggregate around the conductive particles 442. Accordingly, depression regions 440a and non-depression regions 440b having different coating amounts of the adhesive 441 may be formed in the conductive adhesive layer 440. In various embodiments, the conductive particles 442 may have a particle size of 2 micrometers or less based on D50 (median particle size) so as to promote aggregation of the adhesive 441.

Referring to FIG. 8C, in various embodiments, the coating layer 602 of the release film 601 may have defect regions 602a. The defect regions 602a may be regions in which defects (e.g., damage, modification, and/or at least partial removal of a film) are formed in a portion of the coating layer 602. The defects may be generated by means such as laser, heat, and/or corona discharge. Since the defect regions 602a have higher interfacial energy with respect to the adhesive 441 than the coating layer 602, when the adhesive 441 is applied onto a release paper including the defect regions 602a, the adhesive 441 may aggregate around the defect regions 602a. Accordingly, the arrangement of the depression regions 440a of the conductive adhesive layer 440 may be adjusted through the arrangement of the defect regions 602a. For example, by adjusting the arrangement of the defect regions 602a of the release paper, the depression regions 440a may be formed in the portions of the conductive adhesive layer 440 overlapping the regions 430a in which the weft fibers and the warp fibers of the conductive woven layer 430 intersect each other.

Referring to FIG. 8D, in various embodiments, the adhesive 441 and the conductive particles 442 may be applied onto the release film 601 by a roller 603. For example, the roller 603 may include grooves 604 accommodating the adhesive 441 in which the conductive particles 442 are dispersed, and the adhesive 441 and the conductive particles 442 may be applied to specific positions on the release film 601 by the roller 603 in which the grooves 604 are formed. Accordingly, positions at which the depression regions 440a of the conductive adhesive layer 440 are formed may be adjusted through the arrangement of the grooves 604 of the roller 603. For example, the depression regions 440a may be formed in the portions of the conductive adhesive layer 440 overlapping regions 430a in which the weft fibers and the warp fibers of the conductive woven layer 430 intersect each other.

According to various embodiments of the disclosure, an electronic device may include a display 330 configured to output image information on a surface oriented in a first direction. The electronic device may include a conductive contact member 401 disposed on a surface of the display 330 oriented in a direction opposite to the first direction. The conductive contact member 401 may include a conductive woven layer 430 including woven conductive fibers 431. The conductive contact member 401 may include a conductive adhesive layer 440 disposed on one surface of the conductive woven layer 430 so as to form depression regions 440a, and including an adhesive 441 and conductive particles 442. The depression regions 440a may have 10% or less of the adhesive 441 compared to non-depression regions 440b of the conductive adhesive layer 440.

In various embodiments, the conductive adhesive layer 440 may have an area ratio occupied by the depression regions 440a of 30% to 70% when viewed in the first direction.

In various embodiments, the depression regions 440a may have 70% or less of the conductive particles per unit area compared to the non-depression regions 440b.

In various embodiments, the depression regions 440a may be craters formed by a roller 603 having grooves 604.

In various embodiments, the depression regions 440a may be spaced apart from each other by the non-depression regions 440b.

In various embodiments, the conductive contact member 401 may be configured to have a sheet resistance of 200 milliohms/mm² or less when pressure of 25 gf/mm² is applied in the first direction.

In various embodiments, the conductive woven layer 430 may include weft fibers 432 and warp fibers 433 intersecting the weft fibers 432 at an angle.

The conductive woven layer 430 may include gaps 430b formed between the weft fibers 432 and the warp fibers 433. The conductive adhesive layer may be configured such that, when pressure is applied to the one surface of the conductive woven layer 420, the adhesive 441 penetrates into the gaps 430b.

In various embodiments, the depression regions 440a may be positioned to at least partially overlap regions 430a in which the weft fibers 432 and the warp fibers 433 intersect each other.

The second regions 440b may be positioned to at least partially overlap the gaps 430b.

In various embodiments, the conductive adhesive layer 440 may further include a conductive nonwoven fabric 443. The conductive woven layer 420 may make direct electrical contact with the conductive nonwoven fabric 443 in regions in which the weft fibers 432 and the warp fibers 433 intersect each other when pressure is applied to the one surface.

In various embodiments, the conductive adhesive layer 440 may have a thickness of 7 micrometers or more.

A conductive contact member 401 according to various embodiments of the disclosure may include a conductive woven layer 430 including conductive fibers 431 woven to intersect each other.

The conductive contact member 401 may include a conductive adhesive layer 440 disposed on one surface of the conductive woven layer 430 so as to form depression regions 440a, and including an adhesive 441 and conductive particles 442.

The depression regions 440a may have 10% or less of the adhesive 441 compared to non-depression regions 440b of the conductive adhesive layer 440.

In various embodiments, the conductive adhesive layer 440 may have an area ratio occupied by the depression regions 440a of 30% to 70% when viewed in the first direction.

In various embodiments, the depression regions 440a may have 70% or less of the conductive particles per unit area compared to the non-depression regions 440b.

In various embodiments, the depression regions 440a may be craters formed by a roller 603 having grooves 604.

In various embodiments, the depression regions 440a may be spaced apart from each other by the non-depression regions 440b.

In various embodiments, the conductive contact member 401 may be configured to have a sheet resistance of 200 milliohms/mm² or less when pressure of 25 gf/mm² is applied in the first direction.

In various embodiments, the conductive woven layer 430 may include weft fibers 432 and warp fibers 433 intersecting the weft fibers 432 at an angle.

The conductive woven layer may include gaps 430b formed between the weft fibers 432 and the warp fibers 433. The conductive adhesive layer 440 may be configured such that, when pressure is applied to the one surface of the conductive woven layer 420, the adhesive 441 penetrates into the gaps 430b.

In various embodiments, the depression regions 440a may be positioned to at least partially overlap regions 430a in which the weft fibers 432 and the warp fibers 433 intersect each other.

The second regions 440b may be positioned to at least partially overlap the gaps 430b.

In various embodiments, the conductive adhesive layer 440 may further include a conductive nonwoven fabric 443, and the conductive woven layer 420 may make direct electrical contact with the conductive nonwoven fabric 443 in regions in which the weft fibers 432 and the warp fibers 433 intersect each other when pressure is applied to the one surface.

In various embodiments, the conductive adhesive layer 440 may have a thickness of 7 micrometers or more.

A method for manufacturing a conductive contact member 401 according to various embodiments of the disclosure may include a coating operation 501 of applying an adhesive 441 and conductive particles 442 onto a release film 601.

The method for manufacturing the conductive contact member 401 may include an attaching operation 502 of attaching the release film 601, the adhesive 441, and the conductive particles 442 onto a conductive woven layer 430.

The method for manufacturing the conductive contact member 401 may include a removing operation 503 of removing the release film 601 from the conductive woven layer 430.

The release film 601 may include a coating layer 602 configured such that the adhesive 441 applied thereon is unevenly aggregated.

In various embodiments, the conductive particles 442 may have a particle size of 2 micrometers or less based on D50.

In various embodiments, the release film 601 may have a defect formed in a portion of the coating layer 602.

In various embodiments, the coating operation 501 may include an operation of applying the adhesive 441 and the conductive particles 442 onto the release film 601 using a roller 603 having grooves 604 formed to accommodate the adhesive 441 and the conductive particles 442.

The embodiments of the disclosure described and shown in the specification and the drawings are merely specific examples that have been presented to easily explain the technical contents of embodiments of the disclosure and help understanding of embodiments of the disclosure, and are not intended to limit the scope of embodiments of the disclosure. Therefore, the scope of various embodiments of the disclosure should be construed to include, in addition to the embodiments set forth herein, all changes and modifications derived based on the technical idea of various embodiments of the disclosure.

## Claims

1. An electronic device comprising:
a display (330) configured to output image information on a surface oriented in a first direction; and
a conductive contact member (401) disposed on a surface of the display (330) oriented in a direction opposite to the first direction,
wherein the conductive contact member (401) comprises:
a conductive woven layer (430) comprising woven conductive fibers (431); and
a conductive adhesive layer (440) disposed on one surface of the conductive woven layer (430) so as to form depression regions (440a), and comprising an adhesive (441) and conductive particles (442), and
wherein the depression regions (440a) have 10% or less of the adhesive (441) compared to non-depression regions (440b) of the conductive adhesive layer (440).

2. The electronic device of claim 1, wherein the conductive adhesive layer (440) has an area ratio occupied by the depression regions (440a) of 30% to 70% when viewed in the first direction.

3. The electronic device of claim 1, wherein the depression regions (440a) have 70% or less of the conductive particles per unit area compared to the non-depression regions (440b).

4. The electronic device of claim 1, wherein the depression regions (440a) are craters formed by a roller (603) having a groove (604).

5. The electronic device of claim 1, wherein the depression regions (440a) are spaced apart from each other by the non-depression regions (440b).

6. The electronic device of claim 1, wherein the conductive contact member (401) is configured to have a sheet resistance of 200 milliohms/mm² or less when pressure of 25 gf/mm² is applied in the first direction.

7. The electronic device of claim 1, wherein the conductive woven layer (430) comprises:
weft fibers (432);
warp fibers (433) intersecting the weft fibers (432) at an angle; and
gaps (430b) formed between the weft fibers (432) and the warp fibers (433),
wherein the conductive adhesive layer (440) is configured such that, when pressure is applied to the one surface of the conductive woven layer (420), the adhesive (441) penetrates into the gaps (430b).

8. The electronic device of claim 7, wherein the depression regions (440a) are positioned to at least partially overlap regions (430a) in which the weft fibers (432) and the warp fibers (433) intersect each other, and
wherein the second regions (440b) are positioned to at least partially overlap the gaps (430b).

9. The electronic device of claim 7, wherein the conductive adhesive layer (440) further comprises a conductive nonwoven fabric (443), and
wherein the conductive woven layer (420) makes direct electrical contact with the conductive nonwoven fabric (443) in regions in which the weft fibers (432) and the warp fibers (433) intersect each other when pressure is applied to the one surface.

10. The electronic device of claim 1, wherein the conductive adhesive layer (440) has a thickness of 7 micrometers or more.

11. A conductive contact member (401) comprising:
a conductive woven layer (430) comprising conductive fibers (431) woven to intersect each other; and
a conductive adhesive layer (440) disposed on one surface of the conductive woven layer (430) so as to form depression regions (440a), and comprising an adhesive (441) and conductive particles (442),
wherein the depression regions (440a) have 10% or less of the adhesive (441) compared to non-depression regions (440b) of the conductive adhesive layer (440).

12. The conductive contact member of claim 11, wherein the conductive woven layer (430) comprises:
weft fibers (432);
warp fibers (433) intersecting the weft fibers (432) at an angle; and
gaps (430b) formed between the weft fibers (432) and the warp fibers (433), and
wherein the conductive adhesive layer (440) is configured such that, when pressure is applied to the one surface of the conductive woven layer (420), the adhesive (441) penetrates into the gaps (430b).

13. A method for manufacturing a conductive contact member (401), the method comprising:
a coating operation (501) of applying an adhesive (441) and conductive particles (442) onto a release film (601);
an attaching operation (502) of attaching the release film (601), the adhesive (441), and the conductive particles (442) onto a conductive woven layer (430); and
a removing operation (503) of removing the release film (601) from the conductive woven layer (430),
wherein the release film (601) comprises a coating layer (602) configured such that the adhesive (441) applied thereon is unevenly aggregated.

14. The method of claim 13, wherein the release film (601) has a defect formed in a portion of the coating layer (602).

15. The method of claim 13, wherein the coating operation (501) comprises:
an operation of applying the adhesive (441) and the conductive particles (442) onto the release film (601) using a roller (603) having grooves (604) formed to accommodate the adhesive (441) and the conductive particles (442).
